# FASCICULE DE BREVET EUROPEEN

(11) **EP 2 339 630 B1**
(45) Date de publication et mention de la délivrance du brevet: **27.05.2015**
(21) Numéro de dépôt: 10306169.3
(22) Date de dépôt: 26.10.2010
(51) Int. Cl.: H01L 27/146

(54) **Procédé de réalisation d'un composant microélectronique non plan**
Herstellungsverfahren eines unebenen mikroelektronischen Bauelementes
Fabrication process of a non-planar microelectronic device

(30) Priorité: 22.12.2009 FR 0959340
(43) Date de publication de la demande: 29.06.2011
(73) Titulaire: Commissariat à l'Énergie Atomique et aux Énergies Alternatives, 75015 Paris (FR)
(72) Inventeur: Giffard, Benoît, 38000, Grenoble (FR); Cazaux, Yvon, 38100, Grenoble (FR); Moussy, Norbert, 38190, Sainte Agnes (FR)
(74) Mandataire: Vuillermoz, Bruno

(56) Documents cités:
- US-A1- 2006 038 183
- US-A1- 2007 228 502
- US-A1- 2009 115 875

## Description

### DOMAINE DE L'INVENTION

La présente invention a trait à la réalisation de composants microélectroniques courbés concaves. Elle trouve particulièrement application dans le domaine des capteurs d'images.

### ETAT DE LA TECHNIQUE

Les imageurs électroniques comprennent usuellement un capteur d'image plan semiconducteur réalisé en silicium selon la technologie CMOS ou CCD, et une optique qui forme une image de la scène observée sur le capteur d'image.

Toutefois, l'utilisation d'une simple lentille convergente en tant qu'optique n'est pas satisfaisante dans la mesure où l'image formée par une telle lentille n'est pas plane mais sphérique, phénomène connu sous le nom de « courbure de champ ». De fait, l'image projetée par une lentille convergente sur un capteur plan est soit nette au centre mais pas sur les bords soit l'inverse. Ceci explique notamment la fabrication d'optiques complexes, formées de groupes de lentilles, ayant en outre subi des traitements de surface spécifiques afin de conformer les images qu'elles produisent au caractère plan du capteur.

Cependant, même à l'heure actuelle, les optiques les plus complexes introduisent toujours un certain nombre d'aberrations, tant géométriques que chromatiques, au rang desquelles figurent les distorsions en barillet et en coussinet, les aberrations sphériques (ou aberrations dites de « lumière diffuse »), le coma, l'astigmatisme, le vignettage, les éblouissements, la lumière parasite (reflet), ou encore les franges chromatiques.

De telles aberrations nécessitent d'être corrigées, directement lors de la formation des images par l'utilisation d'optiques complexes et encombrantes, et/ou a posteriori par la mise en oeuvre d'algorithmes de traitements d'image nécessitant d'importantes puissances de calcul. Ainsi, la nature plane des capteurs induit directement des aberrations et la correction de celles-ci implique des objectifs encombrants et coûteux ainsi que des calculateurs puissants embarqués dans les caméras et les appareils photographiques numériques.

Une manière efficace de faire disparaître les erreurs induites par la courbure de champ est de modifier la forme du capteur d'image de façon à ce qu'il soit sensiblement de même forme que l'image formée par l'optique. Le fait de pouvoir courber le capteur permet donc, non seulement de corriger les aberrations, mais également de concevoir des caméras et des appareils photographiques compacts et bon marché et ne nécessitant pas de grandes puissances de calcul.

On conçoit donc aisément l'intérêt de concevoir des capteurs courbés dans le domaine de la formation d'image.

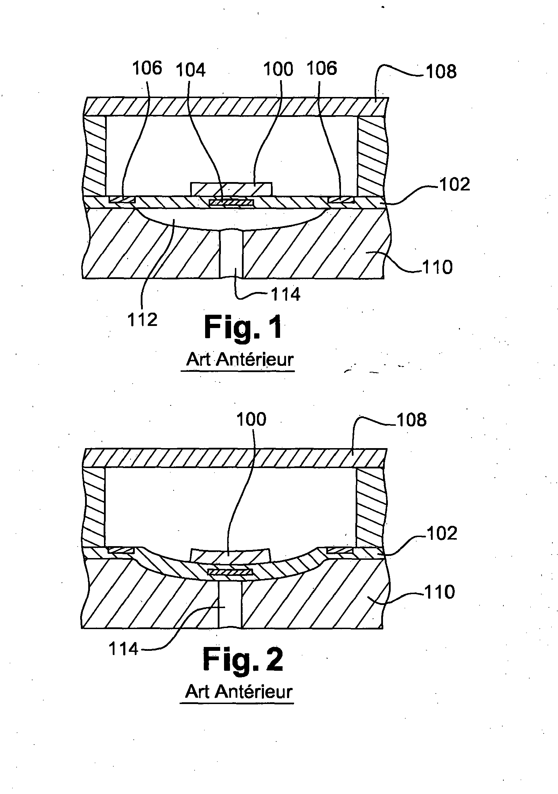

Les figures 1 et 2 illustrent un procédé de fabrication d'un imageur à capteur concave selon l'état de la technique et décrit par exemple, dans le document US 7 390 687.

Selon ce procédé, un capteur plan **100** est tout d'abord réalisé à la surface d'un substrat **102** dans lequel sont par ailleurs réalisés un circuit de lecture **104** dudit capteur **100** ainsi que des connexions **106,** le tout étant encapsulé dans un boitier **108** apte ultérieurement à recevoir une optique (non représentée). Le capteur plan **100** et le substrat **102** sont amincis pour présenter la souplesse nécessaire afin d'être courbés.

Cet ensemble est ensuite reporté sur un deuxième substrat **110** dans lequel est formée une cavité concave **112,** présentant la forme finale recherchée pour le capteur **100.** Un passage **114** est par ailleurs réalisé depuis la face arrière du substrat **110** jusqu'à la cavité **112.**

La cavité **112** est alors mise sous vide. Il se crée ainsi un différentiel de pression qui induit l'affaissement du capteur **100** et du substrat **102** dans la cavité **112.** Ces derniers se conforment ainsi à la cavité **112** et le substrat **102** est solidarisé à la cavité **112** par la présence d'un film de colle préalablement déposé dans la cavité **112.**

Toutefois, le substrat **102** et le capteur **100** sont reportés sur le substrat **110** alors que la cavité **112** est déjà formée. Avant d'être conformé à celle-ci, le substrat **102** et le capteur **100** ne reposent donc sur rien.

De fait, il est difficile, voire impossible, de modifier le substrat **102** et le capteur **100** une fois ceux-ci reportés sur la cavité **112.** Par exemple il est difficile d'ajouter au substrat **102** ou au capteur **100** de nouveaux éléments tels qu'une couche de protection ou des microlentilles. En effet, la modification du substrat **102** et du capteur **100,** que cette modification soit mécanique (polissage, collage, etc...), chimique (dépôt sous vide, attaque par plasma, etc...), ou physique (photolithographie), implique nécessairement d'appliquer une pression sur ceux-ci. Le substrat **102** et le capteur **100** se courbent donc au-dessus de la cavité **112** rendant alors leur modification délicate à l'aide des procédés classiques. Par ailleurs, une variation du différentiel de pression appliqué au substrat **102** et au capteur **100** amène ceux-ci à vibrer, rendant là encore toute modification délicate.

Pour pallier ces inconvénients, il convient alors de contrôler très précisément le différentiel de pression auquel ils sont soumis afin de les maintenir plans à tout instant, ce qui s'avère impossible sans une connaissance précise de la pression exercée par les procédés.

Ainsi, le procédé de l'état de la technique décrit ci-dessus ne permet aucune modification du substrat **102** et du capteur **100** une fois ceux-ci reportés sur la cavité **112.** Ces derniers doivent être réalisés de manière définitive avant leur report. Notamment, ils doivent être reportés alors qu'ils sont souples en raison de leur épaisseur réduite. Le processus de fabrication de l'imageur est donc fortement contraint.

De plus, la souplesse des circuits électroniques réalisés en silicium est usuellement obtenue lorsque leur épaisseur est inférieure à 50 micromètres. A de telles épaisseurs, leur préhension est délicate et toute erreur de manipulation peut induire des pliures ou des vrillages non souhaités. D'ailleurs, dans l'exemple de procédé exposé ci-dessus, le substrat **102** et le capteur **100** sont fixés au boîtier **108** pour faciliter leur manipulation et ainsi gagner en facilité de manipulation, boîtier qui fait obstacle à une modification ultérieure de l'imageur une fois le substrat **102** et le capteur **100** conformés à la cavité **112.**

Le document US 2009/0115875 décrit un procédé de fabrication d'un capteur d'image concave.

### EXPOSE DE L'INVENTION

Le but de la présente invention est de résoudre les problèmes susmentionnés en proposant un procédé alternatif de réalisation d'un composant microélectronique non plan, et notamment concave, à l'aide d'une cavité conformée en conséquence, et par la mise en oeuvre de l'application d'un différentiel de pression, qui diminue sensiblement les contraintes imposées par la réalisation de la concavité et autorise une manipulation aisée de celui-ci à tout instant de sa fabrication.

A cet effet, l'invention a pour objet un procédé de fabrication d'un composant microélectronique non plan, et notamment concave, comprenant la superposition d'une couche intégrant un circuit actif souple au-dessus d'une cavité conformée selon le profil que l'on souhaite conférer audit composant, formée dans un substrat et l'application d'un différentiel de pression de part et d'autre de ladite couche, induisant l'affaissement du circuit souple dans la cavité, et donc sa conformation avec celle-ci.

Selon l'invention, la superposition du circuit souple et de la cavité est réalisée :
■ par remplissage préalable de la cavité par un matériau apte à être enlevé sélectivement par rapport au substrat et au circuit souple ;
■ puis, par report ou formation du circuit souple sur la cavité ainsi remplie ;
■ puis, par formation d'au moins un passage d'accès à la cavité remplie ; et
■ par attaque sélective du matériau remplissant la cavité via le au moins passage d'accès afin d'ôter ledit matériau.

En d'autres termes, une fois la cavité remplie, le substrat recevant celle-ci présente sensiblement les mêmes propriétés mécaniques qu'un substrat plein. De fait, toutes les contraintes liées à la cavité avant l'attaque du matériau remplissant la cavité disparaissent. Notamment, il est possible, au choix, de réaliser directement le circuit souple sur le substrat à l'aide de procédés classiques, de reporter le circuit souple une fois celui-ci fabriqué ou encore de reporter un bloc épais comprenant le circuit souple puis d'amincir celui-ci par des procédés classiques. Il est encore possible de modifier le circuit souple une fois celui-ci superposé au substrat car il repose sur une surface pleine.

Par circuit « souple », on entend un circuit susceptible de se déformer sans engendrer d'altération de sa structure. Typiquement, cette souplesse résulte de l'épaisseur de la couche qui le contient, et s'agissant du silicium, cette couche est d'une épaisseur maximum de 50 micromètres.

Par « concave », on entend ici un volume ménagé en creux.

Par exemple, le circuit souple est constitué d'un circuit CMOS classique, aminci à une épaisseur comprise entre 2 et 50 microns permettant d'obtenir sous pression atmosphérique une courbure du substrat aminci avec une flèche de 10 à 200um.

La formation du ou des passages peut par ailleurs être réalisée une fois le circuit souple superposé sur la cavité, ou bien le circuit souple peut comporter des orifices permettant l'accès au matériau remplissant la cavité.

Selon des modes de réalisation particuliers de l'invention, le procédé comporte une ou plusieurs des caractéristiques suivantes.

Le matériau remplissant la cavité est de la résine apte à être enlevée par un plasma d'oxygène.

Le circuit souple est collé sur le substrat par collage moléculaire. Notamment :
■ le circuit souple est recouvert d'une couche d'oxyde de silicium;
■ le substrat est recouvert d'une couche d'oxyde de silicium une fois la cavité formée et remplie ;
■ le circuit souple est reporté sur le substrat, avec la couche d'oxyde de silicium du circuit souple déposée sur la couche d'oxyde de silicium du substrat ;
■ et un chauffage des couches d'oxyde de silicium est réalisé.

Le chauffage permet notamment de renforcer le collage moléculaire.

Le au moins un passage est bouché en prenant soin de placer la cavité sous une première pression, et par exemple sous vide ou sous pression réduite, le différentiel de pression étant réalisé en soumettant ensuite l'ensemble à une seconde pression supérieure à la première pression.

Selon un mode particulier de réalisation de l'invention, le circuit souple affaissé est solidarisé avec la cavité. Notamment, on recouvre le fond de la cavité d'un premier matériau, et la surface du matériau de remplissage de la cavité d'un second matériau, lesdits premier et second matériaux étant aptes à former un système eutectique. Une fois le matériau de remplissage de la cavité ôté, le circuit souple est solidarisé à la cavité en portant le composant à la température eutectique du système eutectique.

Le composant microélectronique est un capteur d'image. L'invention s'applique toutefois à tout type de composant microélectronique que l'on souhaite courber.

### BREVE DESCRIPTION DES FIGURES

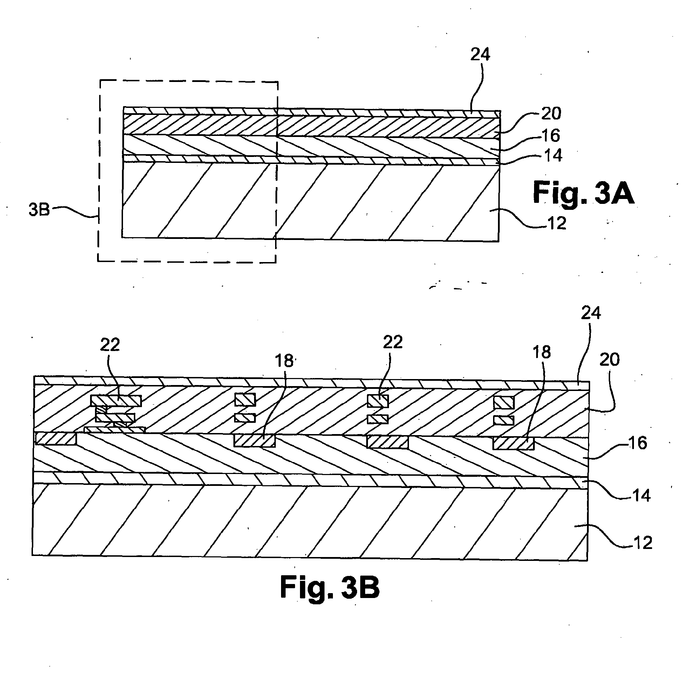

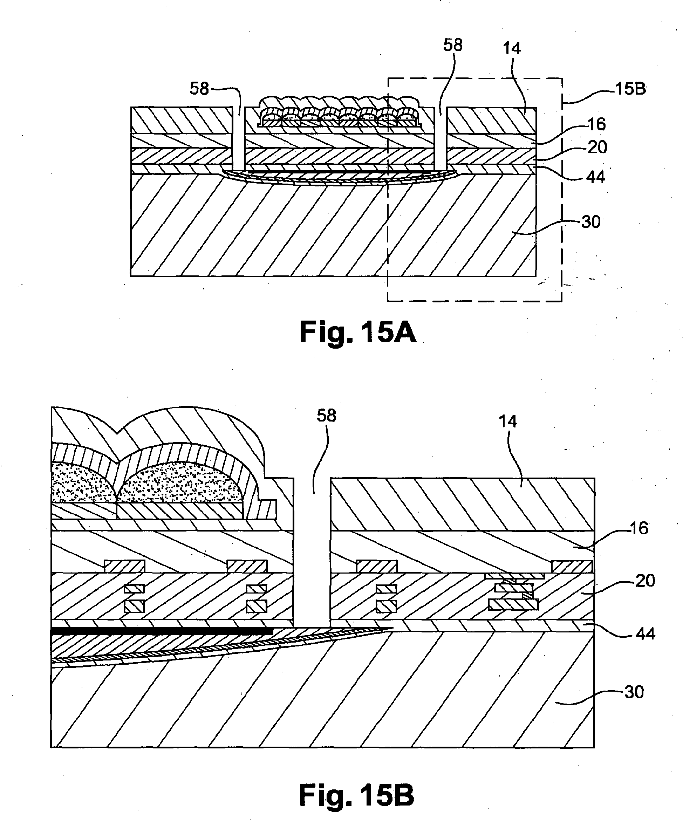

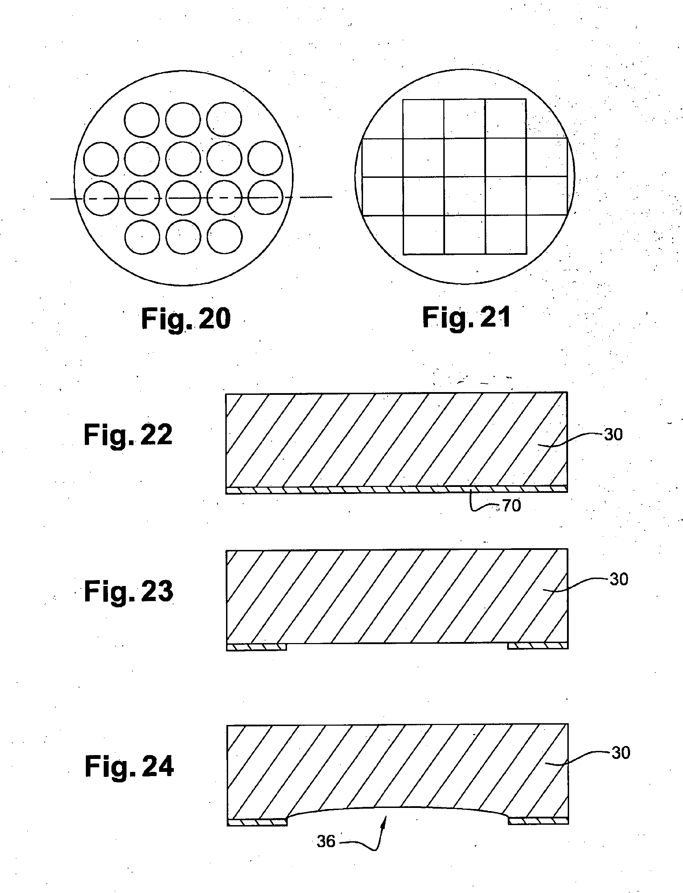

L'invention sera mieux comprise à la lecture de la description qui suit, donnée uniquement à titre d'exemple, et réalisée en relation avec les dessins annexés, dans lesquels des références identiques désignent des éléments identiques ou fonctionnellement analogues, et dans lesquels :
■ les figures 1 et 2 sont des vues schématiques en section d'un imageur électronique à illumination par la face arrière lors de sa fabrication selon un procédé de l'état de la technique ;
■ les figures 3 à 19 sont des vues en section d'un imageur électronique lors de différentes étapes de fabrication selon le procédé selon l'invention ;
■ les figures 20 et 21 sont respectivement des vues de dessus d'un substrat dans lequel sont formées plusieurs cavités et d'une galette comportant une pluralité de capteurs d'image pour une fabrication simultanée de plusieurs imageurs concaves ; et
■ les figures 22 à 24 sont des vues en section d'un substrat dit de poignée lors d'une variante de réalisation d'une cavité concave.

### DESCRIPTION DETAILLEE DE L'INVENTION

Il va à présent être décrit un procédé de fabrication d'un imageur électronique à illumination par la face arrière (ou imageur « *back side* » selon l'expression anglo-saxonne), dont le capteur d'image est concave.

Le procédé débute (figures 3A et 3B) par la formation d'un substrat en silicium **12** épais sur lequel est déposé une couche en SiO₂ **14** d'une épaisseur comprise entre 0,05 et 1 micromètre. La couche **14** servira ultérieurement de couche d'arrêt lors de l'amincissement du substrat **12,** comme cela sera expliqué plus en détail par la suite.

Un circuit de détection en silicium **16,** d'une épaisseur de 2 à 5 micromètres, est formé sur la couche **14** et comporte des éléments unitaires de détection **18** (phototransistors ou photodiodes par exemple), ou « pixels », ainsi que des composants électroniques de traitement analogique et logique de l'imageur. Il constitue donc le circuit actif au sens de l'invention.

Sur le circuit **16** sont réalisées des interconnexions métalliques **22** pour la lecture et la polarisation des composants du circuit **16,** ces interconnexions sont environnées de diélectrique tel que le SiO formant une couche **20,** d'une épaisseur de 1,5 à 4 micromètres..

Enfin, une couche d'oxyde de silicium SiO **24,** d'une épaisseur comprise entre 1 et 5 micromètres, est déposée sur la couche de diélectrique **20** comprenant les interconnexions. La couche **24** est ensuite planarisée, par exemple au moyen d'un polissage mécano-chimique, afin de permettre un collage moléculaire ultérieur avec un autre substrat, dit « substrat poignée », comme cela sera expliqué plus en détail par la suite.

Par exemple, le circuit de détection **16** est un circuit rectangulaire, dont les dimensions sont comprises entre 1 et 5 millimètres, et qui comporte un réseau de pixels de 1 à 10 micromètres de côté pour un nombre total de pixels compris entre 300 000 et 12 000 000.

On retiendra que le circuit de détection **16** et la couche de diélectrique **20** comprenant les interconnexions sont classiques et définissent les couches fonctionnelles du capteur d'image de l'imageur. On notera ici que tout type de capteurs et de technologies (CMOS, CCD) peut être ici réalisé, le choix de ceux-ci étant fonction de l'application visée. Par conséquent, le circuit de détection **16** et la couche de diélectrique **20** comprenant les interconnexions ne seront pas expliqués plus en détail par la suite. On notera simplement que l'épaisseur des éléments **16** et **20** rend ceux-ci souples.

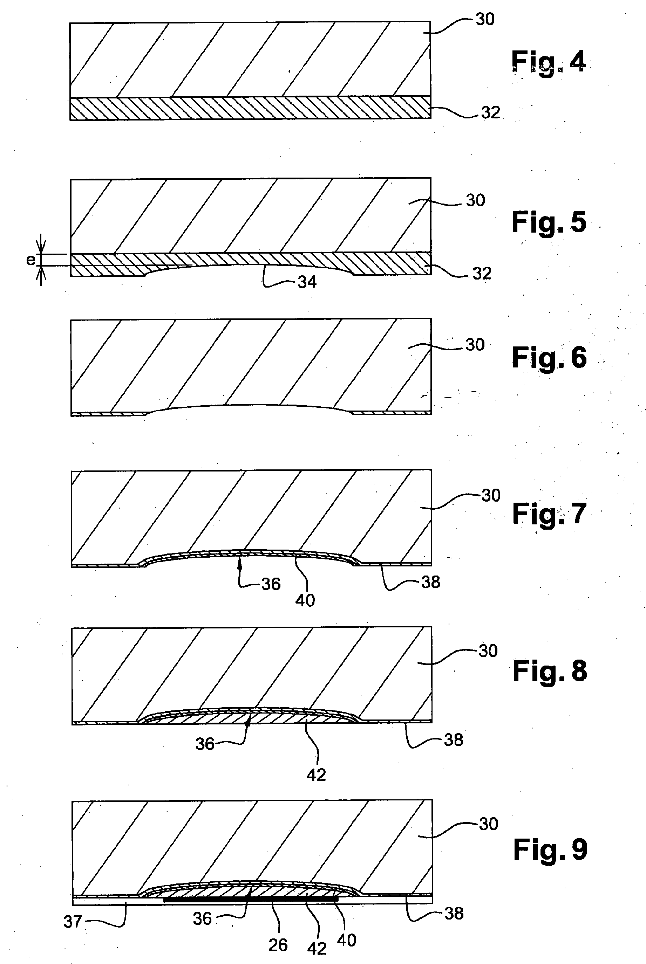

Le procédé comporte par ailleurs la formation d'un substrat en silicium dit « de poignée » **30** sur lequel est réalisé le dépôt d'une couche de résine **32** d'une épaisseur par exemple comprise entre 10 et 100 micromètres (figure 4).

Une cavité concave **34** est alors formée dans la résine **32** à l'aide d'un moule convexe dont la forme est le « négatif » de la forme souhaitée pour le circuit de détection **16** (figure 5). L'épaisseur de la couche de résine **32** est choisie de telle manière que l'épaisseur résiduelle *e* de celle-ci une fois la cavité formée soit la plus fine possible, par exemple de l'ordre de 1 micromètre.

Une gravure ionique est alors réalisée sur la couche de résine **32** avec une sélectivité résine/silicium sensiblement égale à 1. La forme de la cavité **34** imprimée dans la couche de résine **32** est ainsi transférée dans la couche de silicium **30** pour réaliser une cavité concave **36** dans la couche **30** (figure 6). Si la sélectivité de la gravure est égale à 1, la cavité **34** est exactement transférée dans la couche **30.** En variante, la forme de la cavité **34** est transférée avec un facteur d'amplification en choisissant une sélectivité inférieure à 1 ou avec un facteur d'atténuation en choisissant une sélectivité supérieure à 1. Dans une telle variante où une sélectivité différente de 1 est choisie, la forme du moule formant la cavité **34** dans la couche de résine **32** et l'épaisseur de cette couche sont adaptées de manière à obtenir dans la couche de silicium **30** la forme finale souhaitée pour le circuit de détection **16.**

La résine résiduelle est alors retirée de la couche **30** et une oxydation thermique de la couche **30** est réalisée sur une épaisseur **38** comprise entre 50 nanomètres et 0,5 micromètre, par exemple dans un four d'oxydation.

Une couche de métal **40,** d'une épaisseur comprise entre 100 nanomètres et 1 micromètre, est ensuite déposée dans la cavité **36** (figure 7). Le métal est par exemple déposé sur toute la surface de la couche **38** puis le métal déposé hors de la cavité **36** est retiré de manière appropriée, par exemple au moyen d'un masquage suivi d'une attaque chimique sélective par rapport à l'oxyde de silicium **38** ou bien par polissage mécanochimique.

Le métal de la couche **40** constitue l'un des composants d'un système eutectique qui permettra la soudure ultérieure de la couche **24** avec le fond d'une cavité concave, comme cela sera expliqué plus en détail par la suite. Les métaux formant le système eutectique sont choisis pour que la température de fusion de ce système soit inférieure à la température de fusion des matériaux fragiles de l'imageur, notamment le métal des interconnexions de la couche **20** ou encore le matériau de microlentilles ultérieurement formées. Par exemple, le métal de la couche **40** est de l'étain destiné à être combiné avec de l'or pour former le système eutectique dont la température de fusion est inférieure à 240°C.

Le procédé se poursuit alors (figure 8) par le dépôt d'une résine **42** de type polyimide de manière à remplir la cavité **36** suivi du retrait de la résine déposée hors de la cavité **36** afin de laisser libre la couche **38** d'oxyde de silicium sur la portion plane de la couche **30.**

L'ensemble est alors recuit à une température au moins égale à la température maximale que subira ledit ensemble dans la suite du procédé selon l'invention de manière à dégazer préventivement la résine **42** contenue dans la cavité **36.**

Une couche de métal **26,** d'une épaisseur comprise entre 100 nanomètres et 1 micromètre, est déposée sur la résine de remplissage **42** (figure 9). Le métal constitutif de la couche **26** est, pour le système eutectique considéré, le complémentaire du métal constitutif de la couche de métal **40.** Par exemple, si la couche de métal **26** est réalisée en étain, la couche de métal **40** est constituée d'or. Le système eutectique or/étain obtenu présente une température de fusion comprise entre 200°C et 240°C en fonction des proportions relatives de ces deux métaux.

Une couche de diélectrique **37,** par exemple en SiO, d'épaisseur comprise entre 0,1 et 2 micromètres est alors déposée à une température inférieure à la température de recuit précédente pour réaliser le scellement de la cavité **36.**

L'ensemble formant le substrat poignée **30** est alors planarisé par exemple au moyen d'un polissage mécanochimique.

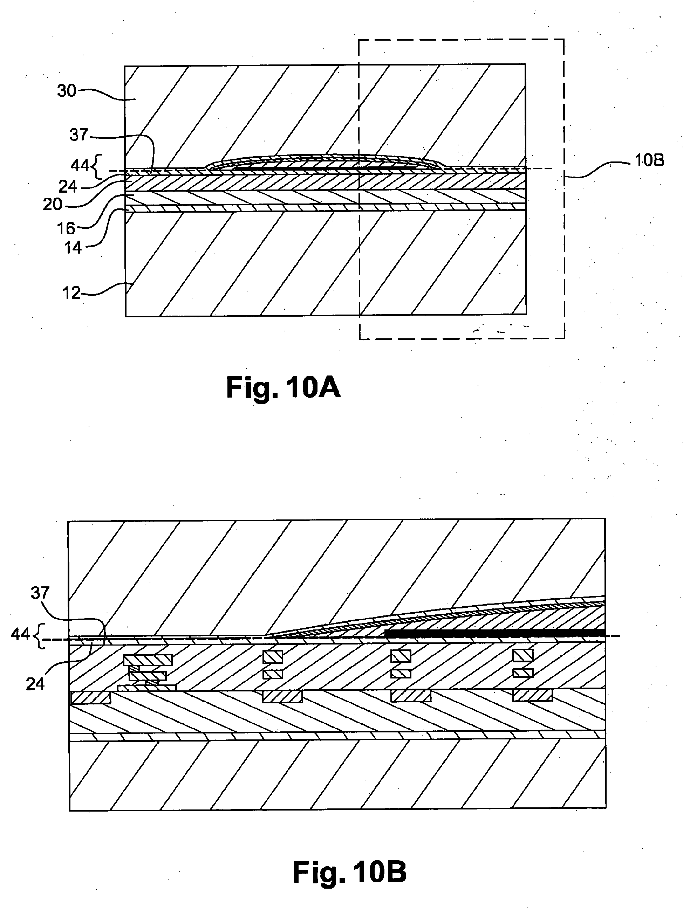

L'ensemble comportant le circuit de détection **16** et l'ensemble formant le substrat poignée **30** sont alors reportés l'un sur l'autre de manière à mettre en correspondance les couches **24** et **37** d'oxyde de silicium (figures 10A et 10B).

Un collage moléculaire à basse température de ces couches est alors réalisé pour solidariser les deux ensembles, puis ce collage est renforcé en chauffant le tout à une température inférieure à la température de recuit de la résine **42.** Une seule couche **44** d'oxyde de silicium est ainsi obtenue.

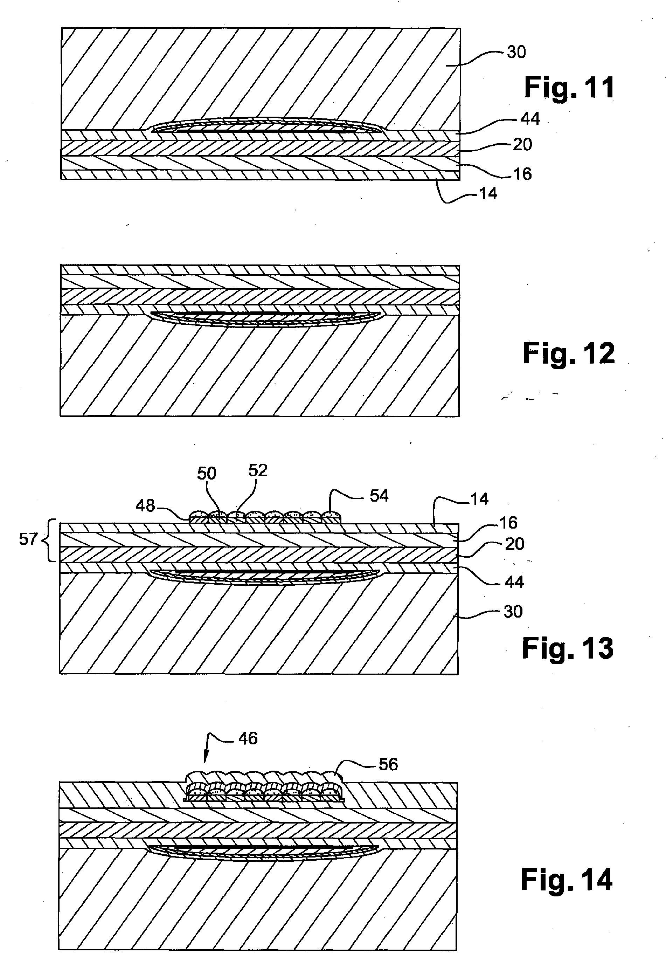

Le substrat **12** agencé sous le circuit de détection **16** est ensuite aminci (figure 11) de manière à pouvoir réaliser une détection de rayonnement électromagnétique par la face arrière **46** de l'imageur, la couche **14** en SiO₂ servant de couche d'arrêt à l'amincissement du substrat **12.**

Dans le mode de réalisation présenté, le substrat **12** est entièrement retiré. Le circuit de détection **16** d'épaisseur comprise entre 1 et 5 micromètres réalise alors la capture des photons comme cela est connu en soi de l'état de la technique des imageurs à illumination par la face arrière.

Une fois l'amincissement du substrat **12** réalisé, l'ensemble est alors retourné (figure 12).

Le procédé se poursuit alors par la finalisation de l'imageur en fonction de l'application visée.

Par exemple, si une détection dans le domaine visible est visée, le procédé se poursuit par le dépôt par photogravure de pastilles de résines colorées en rouge **48,** en vert **50** et en bleu **52** en regard des pixels du circuit de détection **16,** afin de définir un matriçage de détection RVB, comme cela est connu en soi du domaine de la détection en couleurs. Des microlentilles **54** en résine transparente sont ensuite réalisées sur les pastilles de résines **48, 50, 52** afin de focaliser le rayonnement électromagnétique sur les éléments de détection unitaire **18** (figure 3B) du circuit **16** (figure 13). Les microlentilles **54** sont alors durcies par un recuit réalisé à une température comprise entre 200°C et 240°C.

Les microlentilles **54** sont alors protégées par le dépôt d'une résine non durcie **56** sur toute la surface **46** (figure 14), suivi du retrait de ladite résine hors de la zone des microlentilles **54,** pour dégager des surfaces dans lesquelles des puits seront formés, comme expliqué ci-après. Un dépôt à basse température, inférieure à 150°C, d'un oxyde de silicium est ensuite réalisé pour protéger la résine déposée sur les microlentilles **54.** On notera ici que c'est la nature pleine du substrat de poignée **30,** la cavité **36** étant remplie, qui autorise l'utilisation des techniques classiques d'amincissement du substrat **12,** de photolithographie des pastilles de résines **48, 50, 52** ou encore de réalisation des microlentilles **54.**

Une fois la partie détection et optique **57** de l'imageur finalisées, le procédé se poursuit par la courbure de cette partie **57.**

Plus particulièrement, des puits de vidage **58** sont formés par photogravure au travers de la couche **14** du circuit **16,** de la couche **20** et de la couche **44** pour atteindre la cavité **36,** et plus particulièrement la résine **42** remplissant celle-ci. Les puits **58** sont formés en périphérie des pixels du circuit **16** et présentent un diamètre choisi pour un rebouchage ultérieur sans difficulté. Par exemple le diamètre des puits **58** est compris entre 400 nanomètres et 2 micromètres.

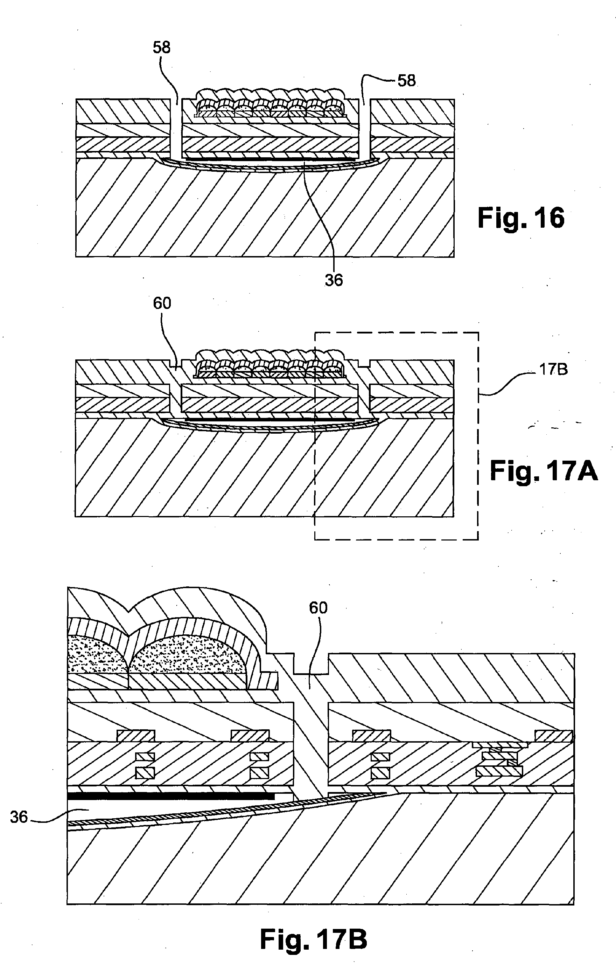

Une fois les puits **58** formés, une attaque sélective de la résine **42** est réalisée, notamment à l'aide d'un plasma d'oxygène amené jusqu'à ladite résine par les puits **58.** Ce plasma d'oxygène est connu pour interagir avec les composés organiques tels que la résine ou le polyimide en créant des composés volatils qui s'échappent par les puits **58.** La résine **42** remplissant la cavité **36** est alors entièrement retirée de celle-ci (figure 16).

Une fois la cavité **36** vidée, celle-ci est à une pression identique à la pression extérieure grâce aux puits **58.** Il n'existe donc à ce stade aucun différentiel de pression entre la cavité et l'environnement, quelle que soit la pression de ce dernier.

Le procédé se poursuit alors par la mise sous vide de l'ensemble et du dépôt sous vide d'un oxyde de silicium **60** de manière à boucher les puits **58** (figures 17A et 17B).

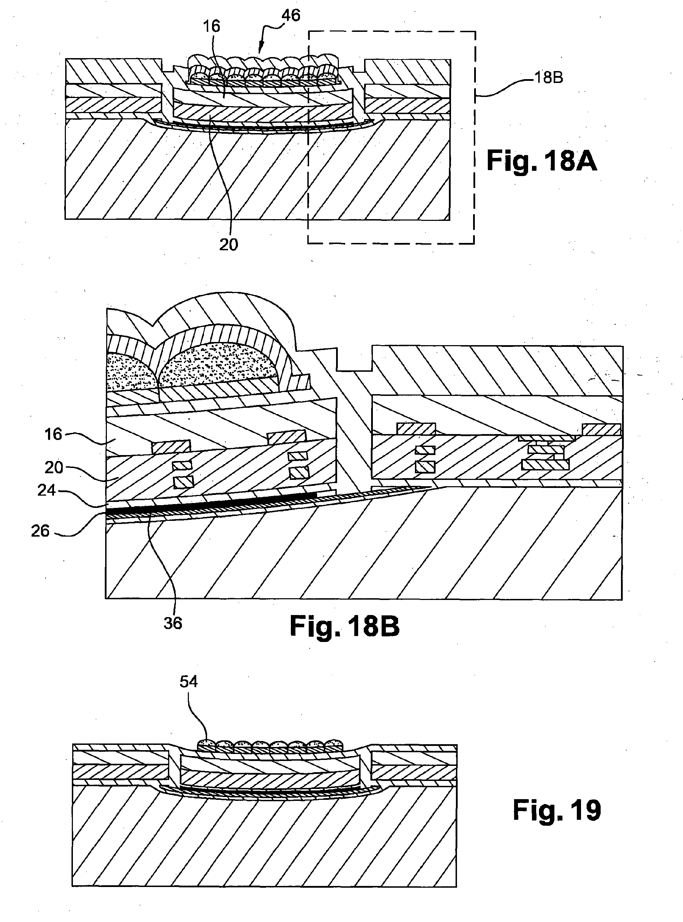

Une fois les puits **58** rebouchés, le vide auquel était soumis l'ensemble est cassé, par exemple par une remise à la pression atmosphérique. Ceci provoque alors l'affaissement des couches agencées au dessus de la cavité **36** et leur conformation à la cavité **36,** notamment celle du circuit de détection **16** (figures 18A et 18B), du fait du différentiel de pression entre le vide régnant au sein de la cavité **36** alors vidée de la résine **42,** et la pression atmosphérique s'exerçant sur la surface **46.**

Le procédé se poursuit alors par le retrait des protections déposées sur les microlentilles **54** (couche de SiO₂ et résine) à l'aide d'une photolithographie. La résine est retirée sélectivement des microlentilles **54** car ces dernières ont été recuites, et donc durcies, à une température d'au moins 200°C alors que la résine de protection a subi un recuit d'une température de 150°C. (figure 19).

L'ensemble est alors porté à la température de fusion du système eutectique or/étain formé des couches **26** et **40,** de sorte que la couche d'oxyde **24,** et par suite toutes les couches formées au dessus de celle-ci, sont solidarisées avec le fond de la cavité.

Il a été décrit la formation d'un capteur concave. Une pluralité de capteurs concaves peut cependant être réalisée simultanément. Par exemple, le substrat poignée comporte une pluralité de cavités, de préférence circulaires pour s'approcher au mieux de la forme concave sphérique recherchée pour les capteurs d'image, formées de la manière décrite précédemment, comme cela est illustré à la figure 20. De manière correspondante, plusieurs circuits de détection et leurs connexions associées peuvent être réalisés dans un même élément, comme cela est illustré à la figure 21.

Les figures 22 à 24 illustrent une variante de fabrication de la cavité **36.** Selon cette variante, un masque dur **70,** d'une épaisseur comprise entre 100 nanomètres et 1 micromètre, est formé à la surface du substrat **30** (figure 22). La dureté du masque **70** est ici définie par rapport à un polissage ultérieur qui n'attaquera pas, ou peu, ledit masque.

Une photogravure du masque **70** est ensuite réalisée à l'endroit où la cavité sera formée dans le substrat **30** (figure 23), puis un polissage mécanochimique est réalisé. Ce type de polissage produit naturellement une surface concave proche de la forme désirée pour la cavité lorsqu'il est appliqué sur une grande surface (figure 24).

La présente invention vient d'être décrite dans le cadre de la fabrication d'un imageur muni d'un capteur concave. On comprendra évidemment que la présente invention trouve application à tout type de composants électroniques nécessitant d'avoir une surface concave. Par exemple, la cavité **36** est plane et inclinée d'un angle prédéterminé par rapport au plan du substrat poignée, de sorte qu'il est obtenu un circuit plan et incliné par rapport au substrat. Des micromiroirs inclinés par rapport à une surface de référence peuvent ainsi être obtenus.

## Revendications

1. Procédé pour la réalisation d'un composant microélectronique non plan, et notamment concave, consistant :
▪ à superposer une couche intégrant un circuit actif souple (16, 20, 24) au-dessus d'une cavité (36) conformée selon le profil souhaité dudit composant, ladite cavité étant formée dans un substrat (30) ; et
▪ à appliquer un différentiel de pression de part et d'autre de ladite couche induisant l'affaissement du circuit souple (16, 20, 24) dans la cavité (36), et donc sa conformation avec celle-ci ;
***caractérisé* en ce que** la superposition du circuit souple (16, 20, 24) et de la cavité (36) est réalisée :
▪ par remplissage de la cavité (36) au moyen d'un matériau (42) apte à être sélectivement enlevé par rapport au substrat (30) et au circuit souple (16, 20, 24) ;
▪ puis, par report ou formation du circuit souple (16, 20, 24) sur la cavité (36) ainsi remplie ;
▪ puis, par formation d'au moins un passage (58) d'accès à la cavité remplie ; et
▪ par attaque sélective du matériau (42) remplissant la cavité (36) via le au moins un passage (58) afin d'ôter ledit matériau.

2. Procédé pour la réalisation d'un composant microélectronique non plan selon la revendication 1, ***caractérisé* en ce que** le matériau (42) remplissant la cavité (36) est de la résine apte à être enlevée par un plasma oxygène.

3. Procédé pour la réalisation d'un composant microélectronique non plan selon l'une des revendications 1 et 2, ***caractérisé* en ce que** le circuit souple (16, 20, 24) est collé sur le substrat (30) par collage moléculaire.

4. Procédé pour la réalisation d'un composant microélectronique non plan selon la revendication 3, *caractérisé :*
▪ en ce que le circuit souple (16, 20, 24) est recouvert d'une couche d'oxyde de silicium (24) ;
▪ en ce que le substrat (30) est recouvert d'une couche d'oxyde de silicium (37) une fois la cavité (36) formée et remplie;
▪ en ce que le circuit souple (16, 20, 24) est reporté sur le substrat (30), avec la couche d'oxyde de silicium (24) du circuit souple (16, 20, 24) déposée sur la couche d'oxyde de silicium (37) du substrat (30) ;
▪ et en ce qu'un chauffage des couches d'oxyde de silicium (24, 37) est réalisé.

5. Procédé pour la réalisation d'un composant microélectronique non plan selon l'une des revendications 1 à 3, ***caractérisé* en ce que** le au moins un passage (58) est bouché après placement de la cavité vidée du matériau (42) sous une première pression, le différentiel de pression étant réalisé en portant ensuite l'ensemble à une seconde pression supérieure à la première pression.

6. Procédé pour la réalisation d'un composant microélectronique non plan selon l'une quelconque des revendications précédentes, ***caractérisé* en ce que** le circuit souple affaissé (16, 20, 24) est solidarisé avec la cavité (36).

7. Procédé pour la réalisation d'un composant microélectronique non plan selon la revendication 6, *caractérisé :*
▪ en ce que le fond de la cavité (36) est recouvert d'un premier matériau ;
▪ en ce que la surface du matériau de remplissage (42) de la cavité est recouverte d'un second matériau, le premier et le second matériau étant apte à former un système eutectique ;
▪ et en ce qu'une fois le matériau (42) remplissant de la cavité (36) a été ôté, le circuit souple (16, 20, 24) est solidarisé à la cavité (36) en portant le composant à la température de fusion eutectique du système eutectique.

8. Procédé pour la réalisation d'un composant microélectronique non plan selon l'une quelconque des revendications précédentes, ***caractérisé* en ce que** le composant microélectronique est un capteur d'image.

## Patentansprüche

1. Verfahren zur Herstellung eines nicht planen und insbesondere konkaven mikroelektronischen Bauteils, das darin besteht:
▪ eine Schicht, die eine flexible aktive Schaltung (16, 20, 24) aufnimmt, über einen Hohlraum (36) zu lagern, der dem gewünschten Profil des Bauteils entspricht, wobei der Hohlraum in einem Substrat (30) ausgebildet ist; und
▪ beidseits der Schicht ein Druckdifferential anzulegen, welches das Absenken der flexiblen Schaltung (16, 20, 24) in den Hohlraum (36) und damit deren Formangleichung an diesen mit sich bringt;
**dadurch gekennzeichnet, dass** die Überlagerung der flexiblen Schaltung (16, 20, 24) und des Hohlraums (36) erfolgt:
▪ durch Füllen des Hohlraums (36) mit einem Material (42), das sich in Bezug auf das Substrat (30) und die flexible Schaltung (16, 20, 24) selektiv entfernen lässt;
▪ dann durch Übertragung oder Ausbildung der flexiblen Schaltung (16, 20, 24) auf den bzw. dem so gefüllten Hohlraum (36);
▪ dann durch Ausbildung mindestens eines Zugangsdurchgangs (58) zum gefüllten Hohlraum; und
▪ durch selektives Ätzen des den Hohlraum (36) füllenden Materials (42) durch den mindestens eine Durchgang (58), um das Material zu entfernen.

2. Verfahren zur Herstellung eines nicht planen mikroelektronischen Bauteils nach Anspruch 1, **dadurch gekennzeichnet, dass** das den Hohlraum (36) füllende Material (42) ein Harz ist, das sich durch ein Sauerstoffplasma entfernen lässt.

3. Verfahren zur Herstellung eines nicht planen mikroelektronischen Bauteils nach einem der Ansprüche 1 und 2, **dadurch gekennzeichnet, dass** die flexible Schaltung (16, 20, 24) durch Molekularklebung auf das Substrat (30) geklebt wird.

4. Verfahren zur Herstellung eines nicht planen mikroelektronischen Bauteils nach Anspruch 3, **dadurch gekennzeichnet**:
▪ dass die flexible Schaltung (16, 20, 24) mit einer Siliciumoxidschicht (24) bedeckt wird;
▪ dass das Substrat (30) mit einer Siliciumoxidschicht (37) bedeckt wird, sobald der Hohlraum (36) ausgebildet und gefüllt ist;
▪ dass die flexible Schaltung (16, 20, 24) auf das Substrat (30) übertragen wird, wobei die Siliciumoxidschicht (24) der flexiblen Schaltung (16, 20, 24) auf der Siliciumoxidschicht (37) des Substrats (30) abgeschieden wird;
▪ und dass eine Erwärmung der Siliciumoxidschichten (24, 37) erfolgt.

5. Verfahren zur Herstellung eines nicht planen mikroelektronischen Bauteils nach einem der Ansprüche 1 bis 3, **dadurch gekennzeichnet, dass** der mindestens eine Durchgang (58) verschlossen wird, nachdem der vom Material (42) entleerte Hohlraum unter einen ersten Druck gesetzt wurde, wobei das Druckdifferential hergestellt wird, indem die Einheit dann auf einen zweitem Druck gebracht wird, der höher ist als der erste Druck.

6. Verfahren zur Herstellung eines nicht planen mikroelektronischen Bauteils nach einem der vorhergehenden Ansprüche, **dadurch gekennzeichnet, dass** die abgesenkte flexible Schaltung (16, 20, 24) mit dem Hohlraum (36) fest verbunden wird.

7. Verfahren zur Herstellung eines nicht planen mikroelektronischen Bauteils nach Anspruch 6, **dadurch gekennzeichnet**:
▪ dass der Boden des Hohlraums (36) mit einem ersten Material bedeckt wird;
▪ dass die Oberfläche des Füllmaterials (42) des Hohlraums mit einem zweiten Material bedeckt wird, wobei das erste und das zweite Material geeignet sind, ein eutektisches System zu bilden;
▪ und dass, sobald das den Hohlraum (36) füllende Material (42) entfernt wurde, die flexible Schaltung (16, 20, 24) mit dem Hohlraum (36) fest verbunden wird, indem das Bauteil auf die eutektische Schmelztemperatur des eutektischen Systems gebracht wird.

8. Verfahren zur Herstellung eines nicht planen mikroelektronischen Bauteils nach einem der vorhergehenden Ansprüche, **dadurch gekennzeichnet, dass** das mikroelektronische Bauteil ein Bildsensor ist.

## Claims

1. A method for producing a non-planar microelectronic component, especially a concave component, involving:
▪ superposing a layer that contains an active flexible circuit (16, 20, 24) above a cavity (36) shaped according to the desired profile of said component, said cavity being formed in substrate (30); and
▪ applying a pressure difference either side of said layer thereby causing slumping of the flexible circuit (16, 20, 24) into the cavity (36) therefore causing the circuit to assume the shape of the cavity;
***characterized* in that** superposition of the flexible circuit (16, 20, 24) and the cavity (36) is realized:
▪ by filling said cavity (36) with a material (42) capable of being selectively removed relative to substrate (30) and flexible circuit (16, 20, 24);
▪ then fitting or forming flexible circuit (16, 20, 24) on cavity (36) thus filled;
▪ then forming at least one feedthrough (58) to access the filled cavity; and
▪ by selectively etching the material (42) that fills cavity (36) through at least one feedthrough (58) in order to remove said material.

2. The method for producing a non-planar microelectronic component as claimed in claim 1, ***characterized* in that** material (42) that fills cavity (36) is a resin capable of being removed by an oxygen plasma.

3. The method for producing a non-planar microelectronic component as claimed in claim 1 or 2, ***characterized* in that** the flexible circuit (16, 20, 24) is bonded on substrate (30) by molecular bonding.

4. The method for producing a non-planar microelectronic component as claimed in claim 3, *characterized:*
▪ in that the flexible circuit (16, 20, 24) is covered by a silicon oxide layer (24);
▪ in that the substrate (30) is covered by a silicon oxide layer (37) once cavity (36) has been formed and filled;
▪ in that the flexible circuit (16, 20, 24) is fitted on substrate (30), with silicon oxide layer (24) of flexible circuit (16, 20, 24) deposited on silicon oxide layer (37) of substrate (30);
▪ and in that the silicon oxide layers (24, 37) are heated.

5. The method for producing a non-planar microelectronic component as claimed in any of claims 1 to 3, ***characterised* in that** at least one feedthrough (58) is stopped up after subjecting the cavity emptied of material (42) to a first pressure, a pressure difference being realized by subjecting the assembly to a second pressure that exceeds the first pressure.

6. The method for producing a non-planar microelectronic component as claimed in any of the above claims, ***characterised* in that** the slumped flexible circuit (16, 20, 24) is attached to cavity (36).

7. The method for producing a non-planar microelectronic component as claimed in claim 6, *characterized:*
▪ in that the bottom of cavity (36) is covered in a first material;
▪ in that the surface of material (42) that fills the cavity is covered in a second material, the first and the second material being capable of forming a eutectic system;
▪ and in that once material (42) that fills cavity (36) has been removed, flexible circuit (16, 20, 24) is attached to cavity (36) by raising the component to the eutectic melting temperature of the eutectic system.

8. The method for producing a non-planar microelectronic component as claimed in any of the above claims, ***characterized* in that** the microelectronic component is an image sensor.
